# EUROPEAN PATENT APPLICATION

(11) **EP 2 581 801 A1**
(43) Date of publication of application: **17.04.2013**
(21) Application number: 11821643.1
(22) Date of filing: 25.08.2011
(51) Int. Cl.: G06F 1/16

(54) **INFORMATION PROCESSING TERMINAL**

(30) Priority: 03.09.2010 JP 2010197815
(71) Applicant: NEC Corporation, Tokyo 108-8001 (JP)
(72) Inventor: HONDA, Kotaro, Tokyo 108-8001 (JP)
(74) Representative: Vossius & Partner
(86) International application number: PCT/JP2011/069171
(87) International publication number: WO 2012/029626

(57) **Abstract**

Provided is an information processing terminal that includes two cases each having a touch-panel display and coupled together by a hinge unit to be openable and closable. The hinge unit is a biaxial hinge having two parallel rotary shafts respectively connected to the two cases and located outside the displays in the axial direction of the rotary shafts.

## Description

### Technical Field '

The present invention relates to an information processing terminal that includes two cases each having a touch-panel display.

### Background Art

A certain information processing terminal such as a portable telephone, a smartphone, a portable information terminal, or a personal computer includes two displays. Such an information processing terminal may be configured such that the two cases respectively that include displays are coupled together to be foldable.

The information processing terminal of such a configuration can be folded compact during carrying and used in various ways, such as simultaneous use of two applications during use and use of one application on a large screen across the two displays.

However, the information processing terminal of such a configuration has a gap between the two displays, and consequently one large image is divided when it is displayed on the two displays. Thus, in the information processing terminal of such a configuration, the two displays must be set as close to each other as possible.

Fig. 1 is an appearance view showing a portable electronic book described in Patent Literature 1. In the portable electronic book described in Patent Literature 1, hinge units X12a and X22a are arranged outside display screens X13 and X23 in an axial direction where two cases (display devices X1 and X2) are coupled together to be openable and closable, thereby enabling arrangement of two display screens X13 and X23 to be close to each other. Further, the portable electronic book is configured so that the surface of two display screens X13 and X23 can match a surface passing through the center of hinge units X12a and X22a.

### Citation List

### Summary of Invention

### Problems to be Solved by Invention

As described above, in the portable electronic book described in Patent Literature 1, a plane including two display screens X13 and X23 matches the surface that passes through the center of hinge units X12a and X22a when two display devices X1 and X2 are opened by 180 degrees. Thus, two display devices X1 and X2 can be brought close to each other.

However, when two display devices X1 and X2 are opened by 180 degrees, hinge unit X12a protrudes in a height direction from the plane including two display screens. X13 and X23. Hinge unit X12a needs to be of a certain size to ensure that the unit has enough strength to ensure that a double spread angle can be freely set.

When display devices X1 and X2 are touch-panel displays, there is a possibility that a finger or a pen may touch hinge units X12a and X22a during a touching operation when the user uses a finger or a pen to touch the display, thereby causing the operability to deteriorate.

It is therefore an object of the present invention to provide an information processing terminal configured such that the gap between two touch-panel displays is narrow and that a touching operation in which the user touches the display is easy.

### Solution to Problem

To achieve the object, according to the present invention, an information processing terminal includes two cases each having a touch-panel display and coupled together by a hinge unit to be openable and closable. The hinge unit is a biaxial hinge having two parallel rotary shafts respectively connected to the two cases and located outside the displays in the axial direction of the rotary shafts.

### Effects of Invention

The present invention can provide an information processing terminal configured such that the gap between two touch-panel displays is narrow and such that a touching operation in which the user touches the display is easy.

### Brief Description of Drawings

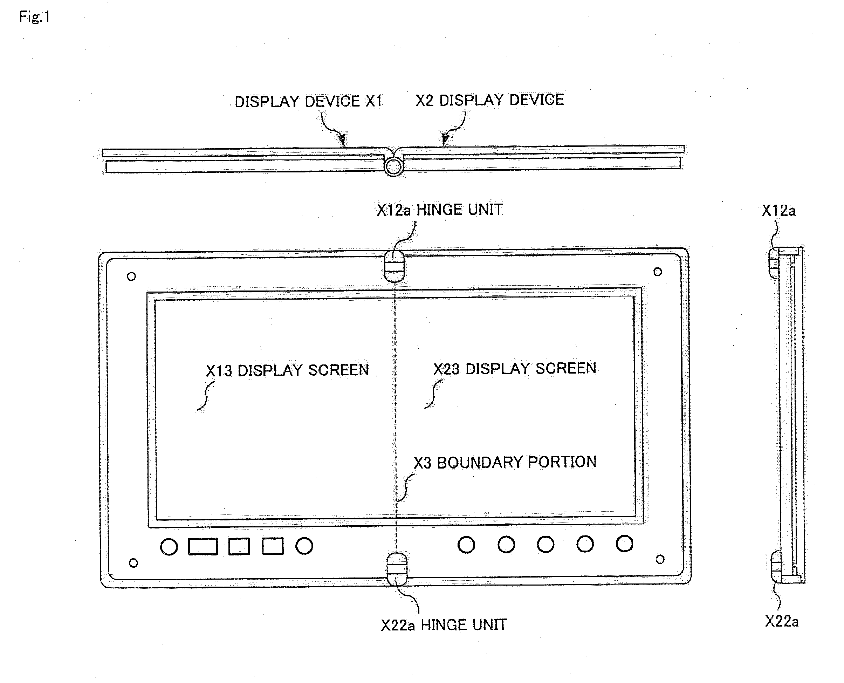

Fig. 1 A view showing a portable electronic book described in Patent Literature 1.
Fig. 2 A perspective view showing an information processing terminal in the opened state according to this embodiment.
Fig. 3 A perspective view showing an information processing terminal in the closed state according to this embodiment.
Fig. 4 A plan view showing the information processing terminal in the opened state according to this embodiment.
Fig. 5 A view schematically showing the peripheral configuration of hinge unit 16.
Fig. 6 An explanatory view showing an arrangement relationship between hinge unit 16 and other portions.

### Description of Embodiment

Hereinafter, the embodiment of the present invention will be described with reference to the drawings.

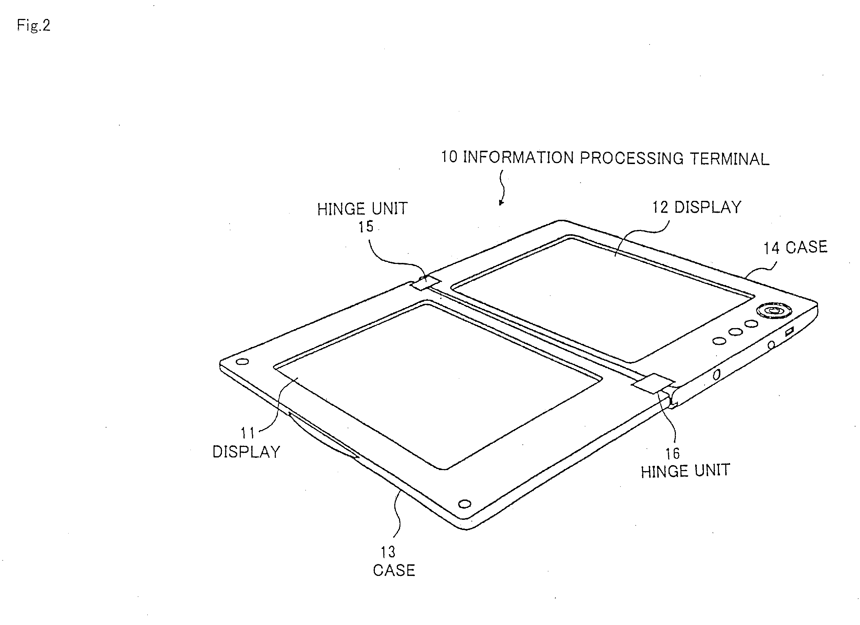

Fig. 2 is a perspective view showing an information processing terminal in the opened state according to this embodiment.

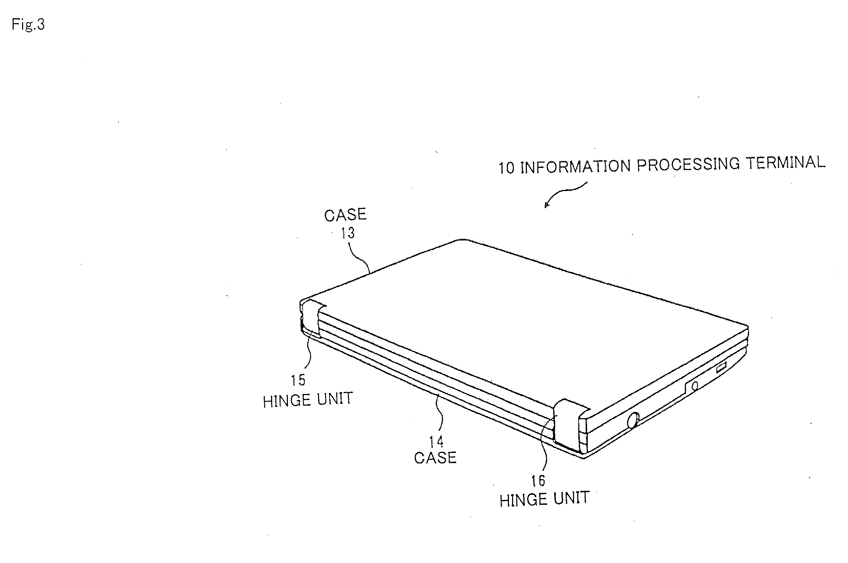

Fig. 3 is a perspective view showing an information processing terminal in the closed state according to this embodiment.

Information processing terminal 10 according to this embodiment is, as an example, a portable information terminal that has a communication function and includes two cases 13 and 14 connected to be openable and closable by hinge units 15 and 16. Cases 13 and 14 respectively include displays 11 and 12.

As shown in Fig. 2, in a state where cases 13 and 14 are open to a 180 degree angle, the display surfaces of two displays 11 and 12 are set in the same direction to simultaneously enter a user's field of view. As shown in Fig. 3, in the closed state of 13 and 14, the display surfaces of two displays 11 and 12 face each other, and displays 11 and 12 are protected by cases 13 and 14. The opening angles of cases 13 and 14 can be freely adjusted between 0 to 180 degrees.

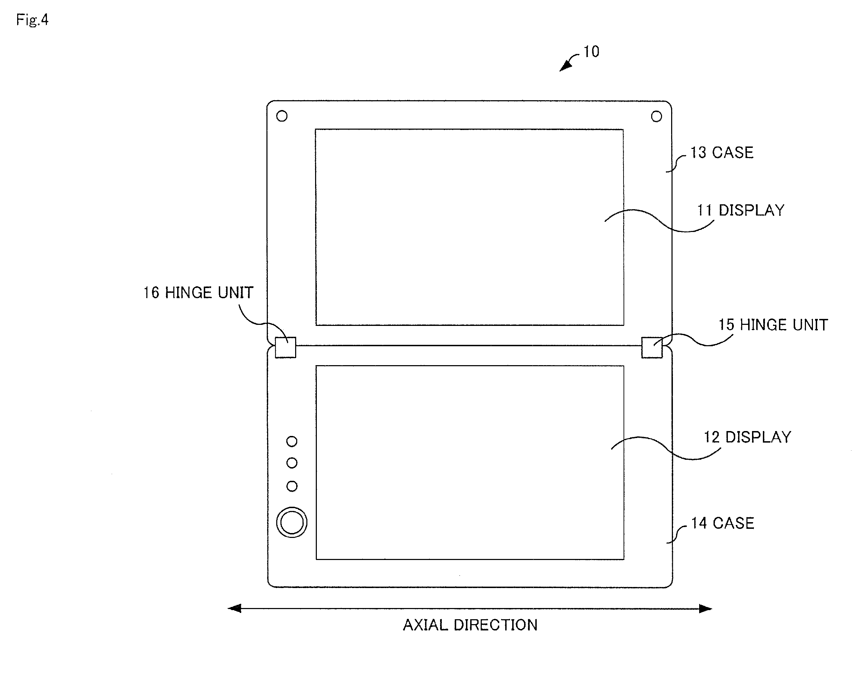

Fig. 4 is a plan view showing the information processing terminal in the opened state according to this embodiment.

Referring to Fig. 4, hinge units 15 and 16 are arranged outside displays 11 and 12 in an axial direction. In Fig. 4, hinge unit 16 is located on the left side of displays 11 and 12 while hinge unit 15 is located on the right side of displays 11 and 12. This prevents overlapping of hinge units 15 and 16 and displays 11 and 12 in a longitudinal direction.

Thus, displays 11 and 12 are arranged near the connection portion of cases 13 and 14 avoiding hinge units 15 and 16, thereby narrowing the gap between displays 11 and 12.

Hinge units 15 and 16 are biaxial hinges having two parallel rotary shafts and are respectively connected to the two cases. Accordingly, even when cases 13 and 14 are brought close to each other, without any protrusion of hinge units 15 and 16 from a plane constituted by displays 11 and 12 opened to 180 degree angle, sufficient strength can be secured, and opening degrees can be freely set.

According to this embodiment, as shown in Fig. 2, the information processing terminal is configured so that when two cases 13 and 14 are opened to a 180 degree angle, the display side surface of cases 13 and 14 can match the surface of hinge units 15 and 16. Thus, the user can smoothly carry out a touching operation without being aware of hinge units 15 and 16 even while touching one or both of cases 13 and 14.

The used biaxial hinge is a general hinge having a hinge mechanism for associatively rotating the two rotary shafts in opposite directions by a gear or a belt. When the two rotary shafts are rotated in the opposite directions, cases 13 and 14 are opened or closed.

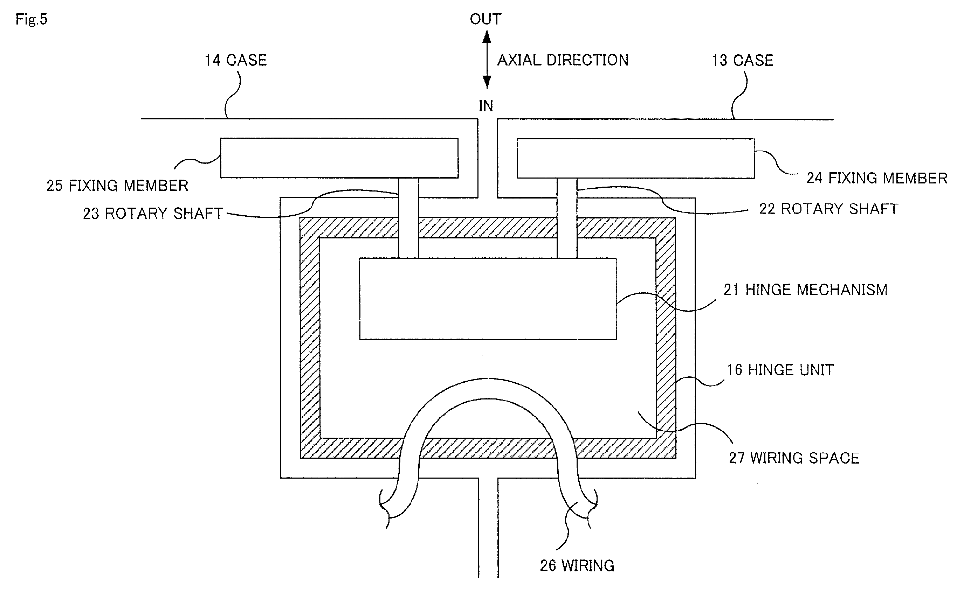

Fig. 5 is a view schematically showing the peripheral configuration of hinge unit 16.

Referring to Fig. 5, hinge unit 16 includes hinge unit 21 for associatively rotating two rotary shafts 22 and 23 and a wiring space 27 through which wiring 26 is passed between cases 13 and 14. This configuration enables, even without using any flat cable, laying of wiring 26 between cases 13 and 14 without increasing the thicknesses of cases 13 and 14.

When a flat cable is used, the cable is exposed in the gap between cases 13 and 14 to cause damage. This necessitates another cover for protection. On the other hand, in this embodiment, since the cable is passed through wiring space 27 of hinge unit 16, the cable is not exposed, and thus safety is assured.

Wiring 26 that passes through hinge unit 16 is a multicore shield cable formed by bundling a plurality of signal lines. By using the multicore shield cable, the noise resistance of the signal lines can be increased.

Hinge mechanism 21 for associatively rotating two rotary shafts 22 and 23 respectively connected to two cases 13 and 14 are arranged outside the axial direction in hinge unit 16. Specifically, in Fig. 5, hinge mechanism 21 is located in an upper side in hinge unit 16. Rotary shafts 22 and 23 are respectively fixed to cases 13 and 14 by fixing members 24 and 25. Wiring 26 passes through wiring space 27 inside hinge mechanism 21 in hinge unit 16. Passing wiring 26 inside hinge mechanism 21 enables prevention of interference between wiring 26 and hinge mechanism 21 or the like and shortening of the wiring length of wiring 26.

Wiring 26 is laid between hinge unit 16 and cases 13 and 14 on the extension to the inside of rotary shafts 22 and 23. Thus, the movement of wiring 26 when cases 13 and 14 are opened or closed can be limited to a minimum, and the fatigue of wiring 26 caused by opening or closing of cases 13 and 14 can be reduced.

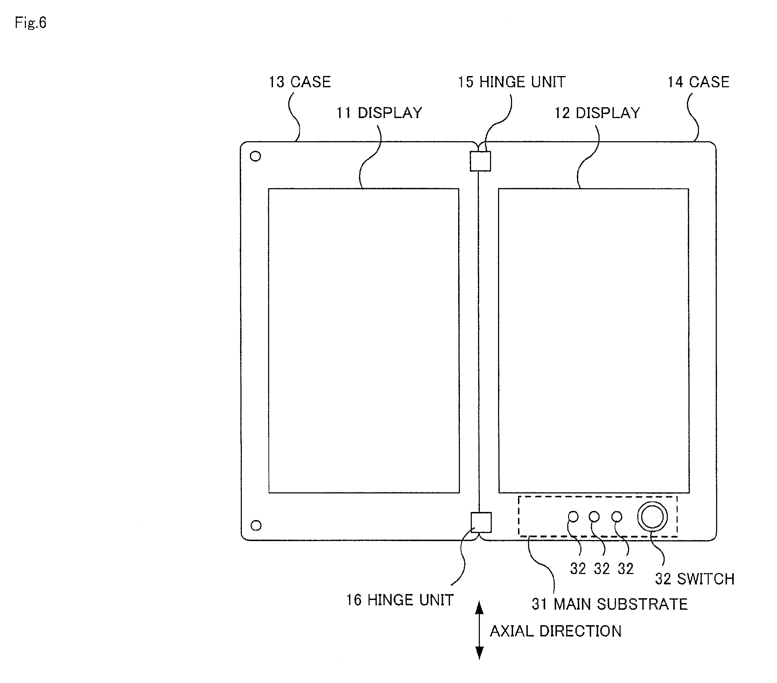

Fig. 6 is an explanatory view showing an arrangement relationship between hinge unit 16 and other portions.

Referring to Fig. 6, switch 32 is disposed in the same position as that of hinge unit 16 in the axial direction of the rotary shaft of case 14. Specifically, in Fig. 6, hinge unit 16 and switch 32 are located side by side below display 12. By disposing hinge unit 16 below display 12 shown in Fig. 6 to bring displays 11 and 12 close to each other, a wide frame portion formed in casing 14 can be used for switch 32, and the display size can be formed large with respect to the device size by efficiently arranging hinge unit 16 and switch 32.

Referring to Fig. 6, main substrate 31 is disposed in the same position as that of hinge unit 16 in the axial direction of the rotary shaft of case 14. Specifically, in Fig. 6, main substrate 31 is located in the same position as that of switch 32 below display 12 in case 14. By disposing hinge unit 16 below display 12 shown in Fig. 6 to bring displays 11 and 12 close to each other, a wide frame portion formed in casing 14 can be used for main substrate 31, and a display size can be formed large with respect to the device size by efficiently arranging hinge unit 16 and main substrate 31.

Further, referring to Fig. 6, in the axial direction, hinge units 15 and 16 are located on both sides of displays 11 and 12. Main substrate 31 is located on one side of displays 11 and 12. The distance between hinge unit 16 of the side where main substrate 31 is located and displays 11 and 12 is longer than that between hinge unit 15 of the side where main substrate 31 is not located and displays 11 and 12. Wiring 26 laid between cases 13 and 14 is mainly connected to main substrate 31 in case 14. Thus, by employing this configuration, on the side where main substrate 31 is located, a space for main substrate 31 can be secured, and a space for laying wiring 26 from main substrate 31 can be secured. On the other hand, on the side where main substrate 31 is not located, the frame width of displays 11 and 12 can be reduced.

The embodiment of the present invention has been described. However, the present invention is not limited to the embodiment. Various changes understandable to those skilled in the art can be made to the configuration and the specifics of the present invention without departing from the scope of the invention.

This application claims priority from Japanese Patent Application No. 2010-197815 filed September 3, 2010, which is hereby incorporated by reference herein in its entirety.

## Claims

1. An information processing terminal comprising:
two cases each having a touch-panel display and coupled together by a hinge unit to be openable and closable,
wherein the hinge unit is a biaxial hinge having two parallel rotary shafts respectively connected to the two cases and located outside the displays in an axial direction of the rotary shafts.

2. The information processing terminal according to claim 1, wherein surfaces of the display sides of the cases match a surface of the hinge unit when the two cases are opened to a 180 degree angle.

3. The information processing tenninal according to claim 1 or 2, wherein wiring between the two cases passes through the hinge unit.

4. The information processing terminal according to claim 3, wherein the wiring passing through the hinge unit is a multicore shield cable formed by bundling a plurality of signal lines.

5. The information processing terminal according to claim 3 or 4, wherein the hinge unit has the two rotary shafts for connecting the two cases and a hinge mechanism for associatively rotating the two rotary shafts arranged outside the axial direction, and wherein the wiring passes through the inside of the hinge mechanism.

6. The information processing terminal according to claim 5, wherein the wiring is laid between the hinge unit and the cases on an extension to the inside of the rotary shafts.

7. The information processing terminal according to any one of claims 1 to 6, wherein a switch is disposed in the same position of the case as that of the hinge unit in the axial direction.

8. The information processing terminal according to any one of claims 1 to 7, wherein a main substrate is disposed in the same position of the case as that of the hinge unit in the axial direction.

9. The information processing terminal according to claim 8, wherein in the axial direction, the hinge units are located on both sides of the display, the main substrate is located on one side of the display, and a distance between the hinge unit on the side of which there is the main substrate and the display is longer than that between the hinge unit on the side of which there is no main substrate and the display.
